# EUROPEAN PATENT SPECIFICATION

(11) **EP 2 501 835 B1**
(45) Date of publication and mention of the grant of the patent: **19.03.2014**
(21) Application number: 10736761.7
(22) Date of filing: 30.06.2010
(51) Int. Cl.: C23C 14/22

(54) **PRODUCTION OF NANOPARTICLES**
HERSTELLUNG VON NANOPARTIKELN
PRODUCTION DE NANOPARTICULES

(30) Priority: 17.06.2009 GB 0910401
(43) Date of publication of application: 26.09.2012
(73) Proprietor: Mantis Deposition Limited, Thame, Oxfordshire OX9 3BX (GB)
(72) Inventor: ALLERS, Lars, Chinnor Oxfordshire OX39 4D (GB); KEAN, Alistair, Watlington Oxfordshire OX49 5LX (GB); WYNNE-POWELL, Thomas Matthew, Oxford OX4 3PB (GB)
(74) Representative: Lord, Michael
(86) International application number: PCT/GB2010/001264
(87) International publication number: WO 2010/146377

(56) References cited:
- GB-A- 2 074 610
- SZIRMAI S G ET AL: "VAPOR COATING OF ELECTROSTATICALLY DISPERSED POWDERS" JOURNAL OF APPLIED PHYSICS, AMERICAN INSTITUTE OF PHYSICS. NEW YORK, US LNKD- DOI:10.1063/1.332999, vol. 55, no. 11, 1 June 1984 (1984-06-01), pages 4088-4094, XP002034283 ISSN: 0021-8979
- BAI JIANMIN ET AL: "High-magnetic-moment core-shell-type FeCo-Au/Ag nanoparticles" APPLIED PHYSICS LETTERS, AIP, AMERICAN INSTITUTE OF PHYSICS, MELVILLE, NY, US LNKD- DOI:10.1063/1.2089171, vol. 87, no. 15, 4 October 2005 (2005-10-04), pages 152502-152502, XP012075963 ISSN: 0003-6951

## Description

### FIELD OF THE INVENTION

The present invention relates to the production of nanoparticles.

### BACKGROUND ART

Nanoparticles can be produced by a range of methods, including vacuum deposition processes. Normal deposition processes call for the material to be evaporated into a vacuum chamber and then deposited onto a substrate. To produce nanoparticles, the evaporated material can be allowed to linger in the gaseous phase to permit nucleation of nanoparticles.

BAI JIANMIN ET AL: "High-magnetic-moment core-shell-type FeCo-Au/Ag nanoparticles", APPLIED PHYSICS LETTERS, AIP, AMERICAN INSTITUTE OF PHYSICS, MELVILLE, NY, US LNKD- DOI: 10.1063/1.2089171, vol. 87, no. 15, 4 October 2005, pages 152502 - 152502, ISSN: 0003-6951 discloses an apparatus for the processing of nano-particles, comprising a sputtering source of moving nano-particles and a physical vapour deposition source (sputter and evaporation sources) of a second material directed toward the nano-particles downstream of the sputtering source.

### SUMMARY OF THE INVENTION

The present invention addresses the problem of creating composite nanoparticles. There is a demand for nanoparticles which comprise an inner core surrounded by an outer shell or coating, for a range of reasons. In some cases, this is because it is the surface of a nanoparticle that is effective, so where the desired material is particularly expensive (such as Platinum) it can be more cost-effective to use the expensive material only on the outer parts of the nanoparticle where it will have some effect. In other cases, a conductive or semi-conductive material can be deposited over a non-conductive core to create a nanoparticle with interesting quantum/electronic properties. In biological systems, a composite nanoparticle can be produce with different properties being shown by the core and the shell. For example, a nanoparticle with a tumour marker on the surface and a potent anti-tumour drug (such as Fe) in the core could be of greater efficacy in that the drug would only be delivered to the tumour and could hence be given at a higher dose than would otherwise be sustainable.

The evident problem lies in the production of such particles. Given that a nanoparticle might consist of a mere 50,000 atoms, this is not a straightforward task.

The present invention therefore provides an apparatus for the processing of nanoparticles according to claim 1.

This works by allowing the charged nanoparticles to encounter a like electrical potential, i.e. an electrical potential that is the same sign as that of the charge on the nanoparticles. As they enter this region, they will slow and, therefore spend a greater time in that region. One or more PVD sources directed at the region will then be able to create a vapour of the intended shell material which will deposit on the slower-moving nanoparticles, increasing their size and creating the desired core/shell structure.

The apparatus for imposing a like potential can comprise one or more conductive rings surrounding the path of the nanoparticles. The like potential can decrease from a maximum to a minimum in the direction of travel of the moving nanoparticles, for example by providing a plurality of conductive rings along the path of the nanoparticles, each at a successively lower potential. This can be achieved by connecting each of the conductive rings to a neighbouring ring by an electrically resistive element, connecting a first conductive ring in the series to a voltage source, and connecting a last conductive ring to an earth. In this way, the approaching nanoparticles initially enter a region of high like potential and decelerate significantly. They then gradually move to areas of lesser like potential, and accelerate down the potential gradient until they leave the structure at approximately the same velocity with which then entered.

The moving nanoparticles may be negatively charged, so the imposed potential may be negative.

The physical vapour deposition source can be one or more of a sputter target, or an evaporative source, or another PVD source. There can be a plurality of physical vapour deposition sources, thereby allowing a larger region in which the shell is deposited. All of the physical vapour deposition sources can deposit the same material, for a uniform shell. Alternatively, different sources could allow for multiple shells or alloy shells.

### BRIEF DESCRIPTION OF THE DRAWINGS

An embodiment of the present invention will now be described by way of example with reference to the accompanying figures, in which:
Figure 1 is a sectional view through an apparatus for producing composite nanoparticles;
Figure 2 shows the conductive rings in more detail; and
Figure 3 shows the variation in electrical potential with distance.

### DETAILED DESCRIPTION OF THE EMBODIMENTS

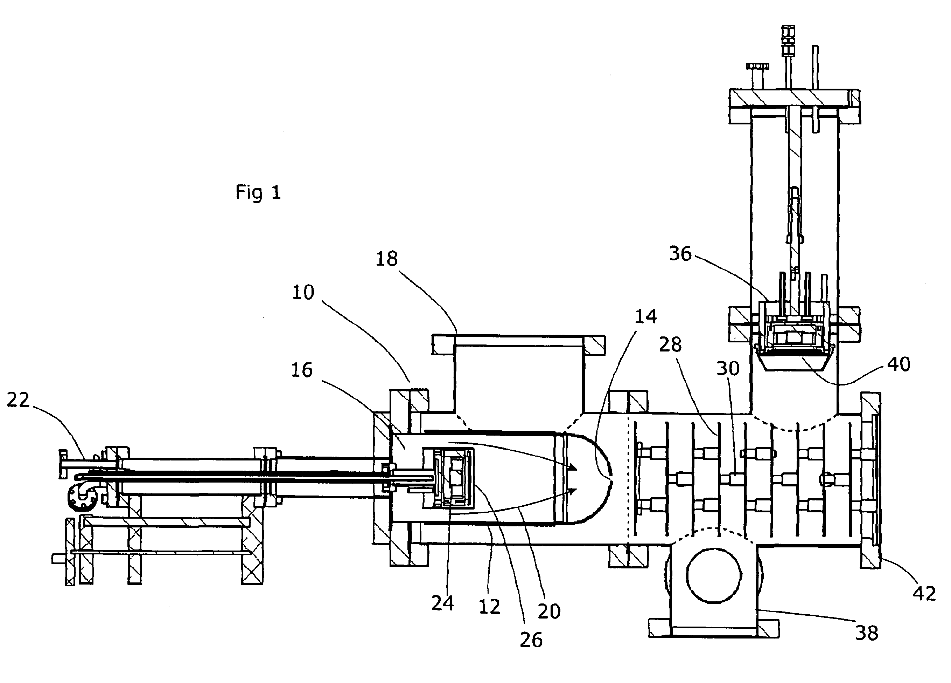

Referring to figure 1, an apparatus for the production of composite nanoparticles is disclosed. This consists of, on the left hand side as illustrated in figure 1, an apparatus 10 for producing nanoparticles. These nanoparticles will eventually form the core of the resulting composites of nanoparticles. An enclosure 12 has an outlet 14 at its right-most end and contains a gas 16 at a low pressure. This is enclosed within a vacuum chamber 18, and accordingly the low pressure gas 16 is at an elevated pressure relative to the surrounding space. As a result, the low pressure gas 16 will escape via the outlet 14, forming a flow of gas as illustrated by arrows 20. A gas inlet 22 is accordingly provided at the left-most end of the enclosure 12, in order to maintain and replenish the supply of low pressure gas 16.

A sputter deposition apparatus 24 is provided within the enclosure 12, and is generally conventional in nature. A sputter target 26 is provided, of the material intended for the core of the nanoparticles to be produced. This sputters material into the low pressure gas 16, generally toward the outlet 14. The sputtered particles become entrained in the gas flow 20 and are subjected to repeated mutual collisions by the low pressure gas 16 during the time that they remain in the flow toward the outlet 14. These collisions, over time, allow the sputtered particles to coalesce into nanoparticles in the manner that we have described previously, for example in GB2430202A, a document that is hereby incorporated by reference and to which the skilled reader is specifically referred for a full understanding of the present invention.

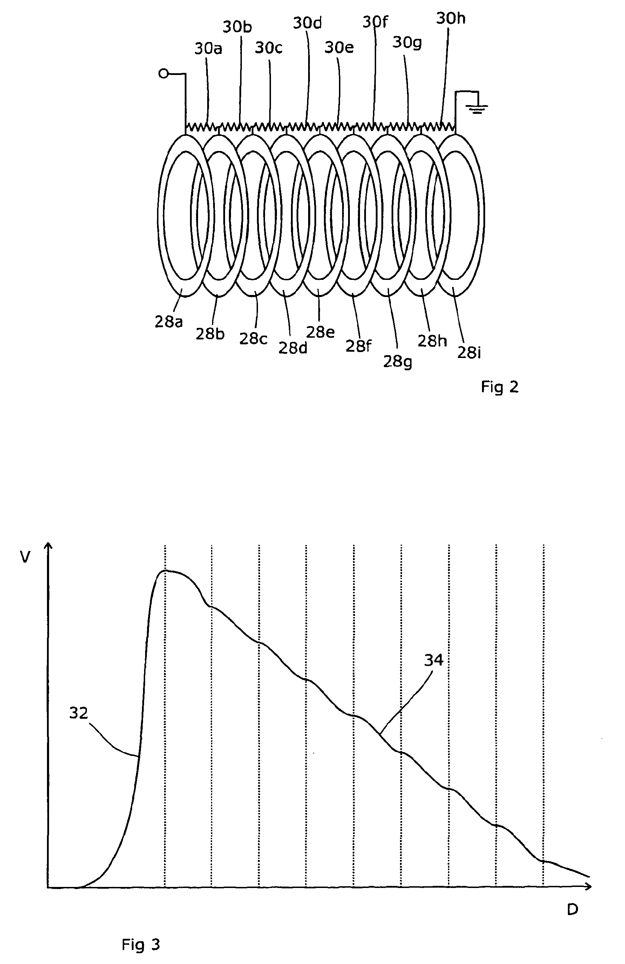

The resulting nanoparticles remain entrained in the gas flow 20 and therefore exit the enclosure 12 through the aperture 14. On exit, they pass through a series of axially spaced conductive rings 28, also shown schematically in figure 2. Each ring 28 is held apart by a spacer 30 (fig 1) which connects one ring to the next. Each spacer 30 is electrically resistive (fig 2), the first ring 28a is connected to an elevated negative voltage, and the last ring 28i is connected to earth. As a result, an electrical current flow from one ring to the next via the resistive spacers, causing a voltage drop to exist over each spacer. Thus, the overall effect of the series of conductive rings is to create a voltage profile as shown in figure 3 in which the nanoparticles, moving from left to right as in figure 1, initially meet a steeply increasing potential 32 (at the first ring 28a), which then decreases gradually in a generally steady slope 34. In fact, each ring is at a potential that is between the supply voltage and ground, dictated by its position along the chain of resistors 30a-30i.

As previously described in GB243020A, the nanoparticles produced by the apparatus 10 are generally negatively charged. This is the reason why the first ring is connected to an elevated negative charge. If an alternative nanoparticle production system were used which produced positively charged nanoparticles, the first ring 28a could be connected to an elevated positive potential instead. The effect of the potential hill 32 that is created in this way is to decelerate the arriving nanoparticles. The voltage of the first ring 28a is set so that this deceleration is insufficient to completely arrest (or repel) the nanoparticles, and therefore they manage to travel past the first ring 28a albeit at a lower velocity. They then meet the successively declining potential 34, which causes them to accelerate towards the last conductive ring 28i.

The last ring 28i is connected to earth, which is the same potential as that at which the nanoparticles started. Thus, the acceleration whilst within the rings 28 exactly balances the initial deceleration encountered at the first ring 28a. However, this initial deceleration followed by the slow regaining of that speed means that the nanoparticles linger in the area of the conductive rings. The varying potential created by the rings establishes a "dwell zone" within the area of those rings.

Two further sputter deposition systems are provided, on either side of the dwell zone. A first sputter deposition apparatus 36 is disposed on one side, and a second sputter deposition apparatus (not shown) is provided with access via port 38 in the vacuum system. These are provided with a second target 40 of a different material which is intended to form the shell of the number particles. Both sputter deposition systems 36 are directed towards the dwell zone and project evaporated material towards it between the conductive rings 28. Accordingly, whilst in the dwell zone, the nanoparticles are allowed to coalesce with the thus-created cloud of the second material, and the resulting nanoparticles have distinct core and shell structures. Eventually, the nanoparticles exit via port 42 after the last conductive ring 28i and can be collected in a conventional manner.

The two sputter deposition systems 36 can be provided with an identical target material 40, for a uniform shell to the nanoparticles. Alternatively, different materials can be provided to allow for multiple shells and/or alloy shells depending on the relative positions of the or each sputter deposition systems relative the dwell zone. A set of sputter targets placed at identical locations along the dwell zone will produce alloy shells, whereas sputter targets spaced along the dwell zone will be able to produce successive shells.

It will of course be understood that many variations may be made to the above-described embodiment without departing from the scope of the present invention.

## Claims

1. Apparatus for the processing of nanoparticles, comprising:
a source of charged nanoparticles of a first material and a first size, said nanoparticles being caused to move along a path;
apparatus for imposing a like potential in a region lying in the path of the nanoparticles, so as to slow the nanoparticles and cause them to dwell for a greater time within the said region; and,
a physical vapour deposition source of a second material directed toward the region, thereby to produce nanoparticles of a second and greater size being a composite of the first and second materials.

2. Apparatus according to claim 1 in which the apparatus for imposing a like potential comprises one or more conductive rings surrounding the path of the nanoparticles.

3. Apparatus according to claim 1 or claim 2 in which the apparatus for imposing a like potential is configured in use such that the like potential decreases from a maximum to a minimum in the direction of travel of the moving nanoparticles.

4. Apparatus according to claim 3 as dependent on claim 2 in which there are a plurality of conductive rings along the path of the nanoparticles, wherein the apparatus for imposing a like potential is arranged such that each ring is at a successively lower potential.

5. Apparatus according to claim 4 in which each of the conductive rings is connected to a neighbouring ring by an electrically resistive element.

6. Apparatus according to claim 5 in which a first conductive ring is connected to a voltage source.

7. Apparatus according to claim 6 in which a last conductive ring is connected to an earth.

8. Apparatus according to any one of the preceding claims in which the source is adapted to provide moving nanoparticles which are negatively charged and wherein the apparatus for imposing a like potential is adapted in use such that the imposed potential is negative.

9. Apparatus according to any one of the preceding claims in which the physical vapour deposition source is a sputter target.

10. Apparatus according to any one of claims 1 to 8 in which the physical vapour deposition source is an evaporative source.

11. Apparatus according to any one of the preceding claims in which there is a plurality of physical vapour deposition sources.

12. Apparatus according to claim 11 in which all of the physical vapour deposition sources are arranged in use to deposit the same material.

## Patentansprüche

1. Vorrichtung für die Verarbeitung von Nanopartikeln, die Folgendes umfasst:
eine Quelle von geladenen Nanopartikeln aus einem ersten Material und mit einer ersten Größe, wobei veranlasst wird, dass sich die Nanopartikel entlang einer Bahn bewegen,
eine Vorrichtung zum Einprägen eines gleichnamigen Potentials in einem Bereich, der in der Bahn der Nanopartikel liegt, um so die Nanopartikel zu verlangsamen und zu veranlassen, dass sie für eine längere Zeit innerhalb des Bereichs verweilen, und
eine Quelle zur physikalischen Gasphasenabscheidung eines zweiten Materials, die auf den Bereich gerichtet ist, um dadurch Nanopartikel mit einer zweiten und größeren Größe zu erzeugen, die ein Verbund aus dem ersten und dem zweiten Material sind.

2. Vorrichtung nach Anspruch 1, wobei die Vorrichtung zum Einprägen eines gleichnamigen Potentials einen oder mehrere leitfähige Ringe umfasst, welche die Bahn der Nanopartikel umgeben.

3. Vorrichtung nach Anspruch 1 oder Anspruch 2, wobei die Vorrichtung zum Einprägen eines gleichnamigen Potentials bei Anwendung derart konfiguriert ist, dass das gleichnamige Potential in der Bewegungsrichtung der sich bewegenden Nanopartikel von einem Maximum zu einem Minimum abnimmt.

4. Vorrichtung nach Anspruch 3, soweit abhängig von Anspruch 2, wobei es mehrere leitfähige Ringe entlang der Bahn der Nanopartikel gibt, wobei die Vorrichtung zum Einprägen eines gleichnamigen Potentials derart angeordnet ist, dass sich jeder Ring bei einem aufeinanderfolgend niedrigeren Potential befindet.

5. Vorrichtung nach Anspruch 4, wobei jeder der leitfähigen Ringe durch ein elektrisches Widerstandselement mit einem benachbarten Ring verbunden ist.

6. Vorrichtung nach Anspruch 5, wobei ein erster leitfähiger Ring mit einer Spannungsquelle verbunden ist.

7. Vorrichtung nach Anspruch 6, wobei ein letzter leitfähiger Ring mit einer Erde verbunden ist.

8. Vorrichtung nach einem der vorhergehenden Ansprüche, wobei die Quelle dafür eingerichtet ist, sich bewegende Nanopartikel bereitzustellen, die negativ geladen sind, und wobei die Vorrichtung zum Einprägen eines gleichnamigen Potentials bei Anwendung derart konfiguriert ist, dass das eingeprägte Potential negativ ist.

9. Vorrichtung nach einem der vorhergehenden Ansprüche, wobei die Quelle zur physikalischen Gasphasenabscheidung ein Sputter-Ziel ist.

10. Vorrichtung nach einem der Ansprüche 1 bis 8, wobei die Quelle zur physikalischen Gasphasenabscheidung eine Verdampfungsquelle ist.

11. Vorrichtung nach einem der vorhergehenden Ansprüche, wobei es mehrere Quellen zur physikalischen Gasphasenabscheidung gibt.

12. Vorrichtung nach Anspruch 11, wobei alle der Quellen zur physikalischen Gasphasenabscheidung bei Anwendung so angeordnet sind, dass sie das gleiche Material abscheiden.

## Revendications

1. Appareil de traitement de nanoparticules, comprenant :
une source de nanoparticules chargées d'un premier matériau et d'une première taille, lesdites nanoparticules étant amenées à se déplacer le long d'un chemin ;
un appareil permettant d'imposer un potentiel de même signe dans une région se trouvant dans le chemin des nanoparticules, de façon à ralentir les nanoparticules et à les amener à rester plus longtemps à l'intérieur de ladite région ; et
une source de dépôt physique en phase vapeur d'un second matériau dirigée vers la région, afin de produire ainsi des nanoparticules d'une seconde taille plus grande qui est un composite des premier et second matériaux.

2. Appareil selon la revendication 1, dans lequel l'appareil permettant d'imposer un potentiel de même signe comprend une ou plusieurs bagues conductrices entourant le chemin des nanoparticules.

3. Appareil selon la revendication 1 ou la revendication 2, dans lequel l'appareil permettant d'imposer un potentiel de même signe est configuré en utilisation de sorte que le potentiel de même signe diminue d'un maximum à un minimum dans la direction de déplacement des nanoparticules mobiles.

4. Appareil selon la revendication 3 lorsqu'elle dépend de la revendication 2, dans lequel, il y a une pluralité de bagues conductrices le long du chemin des nanoparticules, dans lequel l'appareil permettant d'imposer un potentiel de même signe est agencé de sorte que chaque bague est à un potentiel successivement inférieur.

5. Appareil selon la revendication 4, dans lequel chacune des bagues conductrices est connectée à une bague voisine par un élément électriquement résistif.

6. Appareil selon la revendication 5, dans lequel une première bague conductrice est connectée à une source de tension.

7. Appareil selon la revendication 6, dans lequel une dernière bague conductrice est connectée à une terre.

8. Appareil selon l'une quelconque des revendications précédentes, dans lequel la source est adaptée pour fournir des nanoparticules mobiles qui sont chargées négativement et dans lequel l'appareil permettant d'imposer un potentiel de même signe est adapté en utilisation de sorte que le potentiel imposé est négatif.

9. Appareil selon l'une quelconque des revendications précédentes, dans lequel la source de dépôt physique en phase vapeur est une cible de pulvérisation.

10. Appareil selon l'une quelconque des revendications 1 à 8, dans lequel la source de dépôt physique en phase vapeur est une source d'évaporation.

11. Appareil selon l'une quelconque des revendications précédentes, dans lequel il y a une pluralité de sources de dépôt physique en phase vapeur.

12. Appareil selon la revendication 11, dans lequel toutes les sources de dépôt physique en phase vapeur sont agencées en utilisation pour déposer le même matériau.
